# EUROPÄISCHE PATENTANMELDUNG

(11) **EP 0 623 963 A1**
(43) Veröffentlichungstag der Anmeldung: **09.11.1994**
(21) Anmeldenummer: 94106861.1
(22) Anmeldetag: 02.05.1994
(51) Int. Cl.: H01L 29/784, H01L 29/60

(54) **MOSFET auf SOI-Substrat**

(30) Priorität: 06.05.1993 DE 4315064
(71) Anmelder: SIEMENS AKTIENGESELLSCHAFT, D-80333 München (DE)
(72) Erfinder: Neppl, Franz, Dr., D-85521 Ottobrunn (DE); Winnerl, Josef, Dr., D-81929 München (DE)

(57) **Zusammenfassung**

FET, bei dem ein Kanalbereich in einem aus der Siliziumschicht eines SOI-Substrates ausgeätzten Steg (4) ausgebildet ist, den eine Gate-Metallisierung (5) klammerartig umfaßt, wobei zur Ausbildung eines MOSFET eine Dielektrikumschicht (6) zwischen der Gate-Metallisierung (5) und dem Steg (4) vorhanden ist und Source- und Drain-Gebiete durch Dotierungen (7) gegeben sind.

## Beschreibung

Die vorliegende Erfindung betrifft MOSFETs, insbesondere völlig verarmte CMOS-Transistoren auf einem SOI-Substrat.

Völlig verarmte (fully depleted) CMOS-Transistoren werden im Bereich unterhalb 0,25 µm Kanallänge auf SOI-Substraten (Silicon on Insulator) mit extrem dünnen Siliziumschichten (kleiner als 150 nm) an der Oberfläche hergestellt. Das verfügbare Silizum-Volumen ist in diesem Fall kleiner als die sich ausbildenden Verarmungszonen und die Transistoren sind daher völlig verarmt. Die dünnen Siliziumschichten werden entweder in SIMOX-Technik oder durch wafer bonding von Substraten hergestellt. SIMOX-Substrate erreichen eine gute Gleichmäßigkeit der dünnen Siliziumschicht, weisen aber nur eine mäßige Qualität der Grenzfläche zwischen Silizium und Isolator auf. Dadurch können die Eigenschaften des MOSFET beeinträchtigt werden. Mit wafer bonding ergeben sich optimale Silizium-Oxid-Grenzflächen. Der Verfahrensschritt des Polierens bei der Herstellung der extrem dünnen Oberflächenschicht aus Silizium mit geringsten Toleranzen ist jedoch äußerst kritisch.

Aufgabe der vorliegenden Erfindung ist es, einen einfach herstellbaren Feldeffekttransistor für kleinste Abmessungen, insbesondere als völlig verarmten CMOS-Transistor, auf SOI-Substrat anzugeben.

Diese Aufgabe wird mit dem Feldeffekttransistor mit den Merkmalen des Anspruches 1 gelöst. Weitere Ausgestaltungen ergeben sich aus den abhängigen Ansprüchen.

Der erfindungsgemäße FET ist vertikal auf einem SOI-Substrat angeordnet. Das Halbleitermaterial dieses FET befindet sich in der Form eines schmalen Steges, der aus der Siliziumschicht eines SOI-Substrates hergestellt wurde, indem das Material der Siliziumschicht in einem Bereich um diesen Steg vollständig von der Isolatorschicht (Oxidschicht) entfernt wurde. Der Kanalbereich und die Bereiche von Source und Drain sind durch entsprechende Dotierungen in diesem Steg ausgebildet. Die Metallisierungen, insbesondere die Gate-Elektrode, sind klammerartig den Steg umfassende Metallkontakte. Die Länge des Gates wird durch die Breite der Gate-Metallisierung bestimmt. Da sich die Gateelektrode auf beiden Seiten des Steges mit dem Kanalbereich befindet, wird der Kanal von zwei Seiten her eingeschnürt bzw. geöffnet. Es kann daher zur Erreichung von völlig verarmten CMOS-Transistoren die Breite des Steges größer sein, als die Schichtdicke des Kanalbereiches bei einer üblichen Anordnung in zur Oberfläche des Substrates koplanaren Schichten betragen würde. Die Anforderung an die Dicke der Siliziumschicht des SOI-Substrates ist dabei weniger restriktiv, da diese Dicke nur die Transistorweite bestimmt, für die Ausbildung eines verarmten Kanalgebietes aber bedeutungslos ist.

Es folgt eine Beschreibung des erfindungsgemäßen Transistors anhand der Figuren 1 bis 6.
- Fig. 1 bis 4: zeigen den Transistor in einer perspektivischen Schnittaufsicht nach verschiedenen Schritten des Herstellungsverfahrens.
- Fig. 5 und 6: zeigen entsprechende perspektivische Schnittaufsichten für alternative Ausführungsbeispiele.

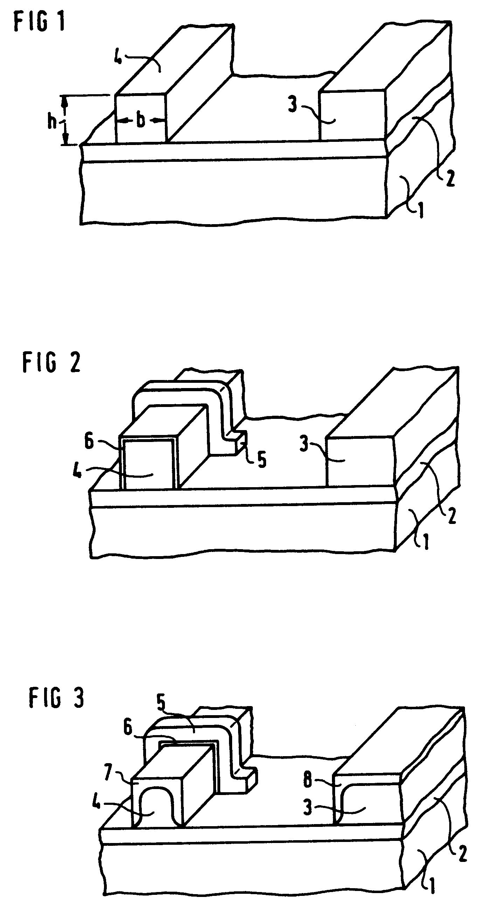

Die Struktur des Transistors wird jetzt anhand des Herstellungsverfahrens näher erläutert. Auf einem Substrat 1 mit einer Isolatorschicht 2 und einer darauf angeordneten Siliziumschicht 3 wird für jeden Transistor ein Steg 4 aus dieser Siliziumschicht 3 (s. Fig. 1) ausgeätzt. Das Substrat kann ein SOI-Substrat sein. Es wird allerdings ein SOI-Substrat mit einer deutlich dickeren Oberflächenschicht aus Silizium verwendet, als sonst üblich ist. In Fig. 1 ist der Steg 4 bis zur Oberfläche der Isolatorschicht 2 (z. B. SiO₂) z. B. durch anisotropes Ätzen hergestellt. Die Höhe h des Steges entspricht der Dicke der Siliziumschicht 3, die z. B. 0,5 µm bis 1 µm beträgt. Die Breite b des Steges 4 sollte vorzugsweise kleiner als 0,3 µm sein, wenn vollständig verarmte Transistoren hergestellt werden sollen. Die Isolatorschicht 2 wirkt bei dieser Herstellung als Ätzstoppschicht. Der oder die Stege 4 liegen mit der Längsrichtung vorzugsweise in (100)-Richtung und sind Mono-Silizium. Entsprechend Fig. 2 werden die Stege 4 auf der gesamten Oberfläche mit einer Dielektrikumschicht 6 als Gatedielektrikum versehen. Das kann z. B. durch Oxidation der Oberfläche mittels RTO (rapid thermal oxidation) geschehen, was gleichmäßige Dicke der Dielektrikumschicht 6 auch an den Kanten liefert. Anschließend wird die Gate-Metallisierung 5 unter Verwendung üblicher Maskentechnik auf den Steg aufgebracht. Diese Gate-Metallisierung umfaßt wie in Fig. 2 dargestellt den Steg klammerartig etwa in der Mitte.

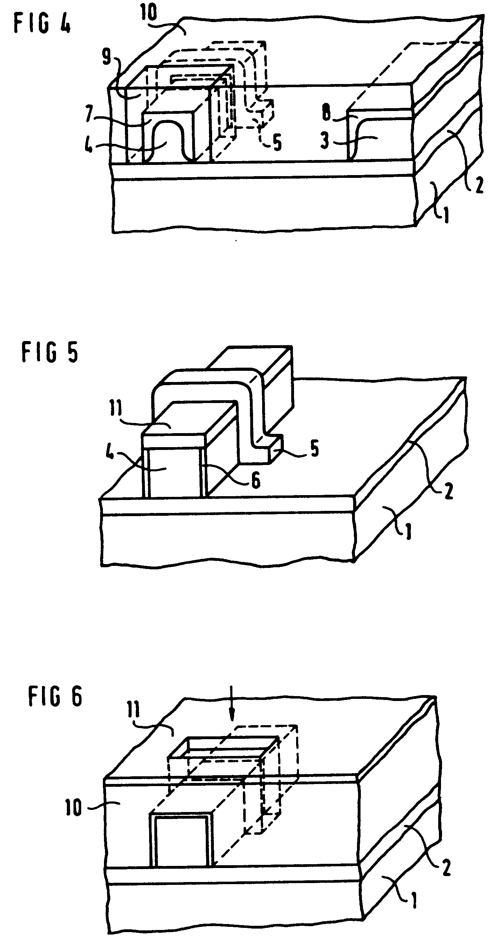

Es können dann die Source- und Drain-Bereiche durch z. B. Ionenimplantation unter relativ großen Winkeln in die Längsseitenwände der Stege dotiert werden. Die Dotierung kann auch aus der Gasphase erfolgen. Diese Implantierung ist in Fig. 3 durch die Pfeile angedeutet. Es ergeben sich auf diese Weise dotierte Gebiete 7 in dem Steg 4 und dotierte Gebiete 8 in dem in Fig. 3 eingezeichneten restlichen Material der ursprünglichen Siliziumschicht 3. Die Breite der Stege 4 entspricht bei dieser Transistorstruktur der verfügbaren Transistortiefe, d. h. der Dicke der bei der üblichen Struktur des Transistors vorgesehenen aktiven Schichtstruktur. Da bei der speziellen Gestaltung der Gate-Metallisierung 5 die Steuerung des Transistors von zwei Seiten erfolgt, ist die Verarmungszone im Kanal doppelt so tief. Die Breite des Steges braucht daher nicht ganz so gering zu sein wie die Transistortiefe bei herkömmlichen Strukturen. Die Dicke der Siliziumschicht 3, aus der der Steg 4 geätzt wurde, bestimmt nur noch die Weite des Transistors (Breite des Kanales) und ist daher unkritischer. Es brauchen daher keine so engen Toleranzen bei der Herstellung eingehalten zu werden. Zur Erzeugung von CMOS-Strukturen (s. z. B. S.M. Sze: Semiconductor Devices, Wiley 1985, S. 492 - 497) können die Stege für NMOS und PMOS zunächst entsprechend vordotiert werden. Die Source- und Drain-Gebiete müssen getrennt selektiv für beide Transistortypen hergestellt werden. Schließlich wird die Oberfläche mit einer Dielektrikumsschicht 10 (s. Fig. 4) bedeckt und planarisiert. Diese Schicht kann z. B. ein isolierendes Oxid (z. B. SiO₂) sein. Zur Erleichterung einer globalen Planarisierung können bei der Herstellung der Stege 4 aus Mono-Silizium in den nicht aktiven Bereichen größere Flächen der ursprünglichen Siliziumschicht 3 stehen bleiben, wie das in den Figuren auf der rechten Seite eingezeichnet ist. Die Kontaktlöcher zu den Source-Gebieten und Drain-Gebieten werden in die Dielektrikumsschicht 10 geätzt und die Öffnungen mit Metall, z. B. Wolfram, gefüllt. Eine derartige Metallisierung 9 ist in Fig. 4 eingezeichnet. Diese Metallisierung 9 ist ebenfalls in einer den Steg 4 klammerartig umfassenden Weise ausgebildet. Das Metall an der Oberfläche wird ggf. rückgeätzt oder durch Polieren planarisiert. In Fig. 4 ist der Übersichtlichkeit halber nur auf einer Seite der Gate-Metallisierung 5 eine weitere Metallisierung 9 eingezeichnet. Durch die planare Deckschicht 10 und die ebene Oberfläche dieser Metallisierungen ist erreicht, daß die Oberfläche dieser Transistorstruktur für mögliche weitere Leiterbahnen planar ist.

Das Problem der hohen erforderlichen Selektivität bei der Ätzung der Gate-Metallisierung kann dadurch entschärft werden, daß auf die Oberseite des Steges eine weitere, dickere Dielektrikumschicht 11 (z. B. SiO₂) aufgebracht wird, wie in Fig. 5 dargestellt ist. Dadurch wird außerdem das eventuell kritische Transistorsegment an den Stegkanten eliminiert. Nachdem die Gate-Metallisierung 5 aufgebracht ist, wird diese weitere Dielektrikumschicht 11 zusammen mit der zuvor aufgebrachten Dielektrikumschicht 6 seitlich der Gate-Metallisierung 5 von dem Steg 4 entfernt.

Eine Alternative zur vollständigen Vermeidung des Selektivitätsproblems ist folgende:
Es ist nicht erforderlich, diese Gate-Metallisierung 5 nachträglich zu strukturieren, wenn die Metallisierung nur in dem vorgesehenen Bereich aufgebracht wird. Das kann z. B. entsprechend der Figur 6 dadurch geschehen, daß eine planare Hilfsschicht 10 ganzflächig aufgebracht wird, die den Steg 4 vollständig überdeckt. Diese Hilfsschicht 10 wird unter Verwendung einer Maskenschicht 11 strukturiert. Die Hilfsschicht 10 wird z. B. in der Richtung des in Fig. 6 eingezeichneten Pfeiles anisotrop im Bereich des Gate ausgeätzt. Die entstehende Öffnung wird dann mit dem Material der Gate-Metallisierung aufgefüllt. Die Hilfsschicht kann dann für die weitere Bearbeitung des Transistors entfernt werden. Überschüssiges Metall wird zuvor z. B. durch Rückätzen oder chemisch-mechanisches Polieren (CMP) entfernt. Mit dieser Technik können extrem kurze Gatelängen (d. h. schmale Gate-Metallisierungen) ohne aggressive Lithographie durch CARL und ähnliche Techniken erreicht werden.

Die erfindungsgemäße Struktur des Feldeffekttransistors ist für verschiedene Transistorstrukturen leicht abzuwandeln. Insbesondere kann die für einen MOSFET vorgesehene Dielektrikumschicht 6 entfallen (MESFET) oder durch andere Schichten ersetzt sein. Das Herstellungsverfahren für vertikale CMOSFETs besitzt alle Vorteile der SOI-Technologie für völlig verarmte Transistoren. Der Platzbedarf für MOSFETs einer bestimmten Stromergiebigkeit wird aber deutlich verringert. Es werden keine problematischen extrem dünnen Siliziumschichten von SOI-Substraten benötigt. Einflüsse der Grenzfläche zwischen Silizium- und Oxidschicht sind wegen des geringen Flächenanteiles (schmale Stege) klein. Diese Technologie läßt sich außerdem wegen der relativ großen Dicke der verwendeten Siliziumschicht ggf. mit in größeren übrig gebliebenen Bereichen dieser Siliziumschicht realisierten Standard-Volumen-Funktionselementen kombinieren. Derartige Funktionselemente sind z. B. Siliziumtransistoren in Standardstruktur wie CMOS, Bipolartransistoren oder spezielle ESD-Strukturen. Der erfindungsgemäße FET läßt sich den jeweiligen Anforderungen entsprechend abwandeln, wobei die jeweils realisierte vertikale Anordnung des Kanalbereiches als Steg der Halbleiterschicht eines SOI-Substrates die einfache Herstellbarkeit garantiert.

## Patentansprüche

1. Feldeffekttransistor,
bei dem ein Kanalbereich für ein Gate an den drei Oberflächen eines Steges (4) aus Halbleitermaterial ausgebildet ist,
bei dem eine Gate-Metallisierung (5) vorhanden ist, die quer zur Längsrichtung dieses Steges (4) den Steg (4) klammerartig umschließt,
bei dem beidseitig dieses Gates in diesem Steg (4) Source- und Drain-Bereiche ausgebildet sind und
bei dem auf diesen Source- und Drain-Bereichen Metallisierungen als Source-Kontakt und als Drain-Kontakt aufgebracht sind.

2. FET nach Anspruch 1,
bei dem zwischen dem Halbleitermaterial des Steges (4) und der Gate-Metallisierung (5) eine Dielektrikumschicht (6) vorhanden ist.

3. FET nach Anspruch 2,
bei dem der Steg (4) so schmal ist, daß der FET als völlig verarmter (fully depleted) CMOS-Transistor ausgebildet ist.

4. FET nach einem der Ansprüche 1 bis 3,
bei dem der Steg (4) in der Siliziumschicht eines SOI-Substrates ausgebildet ist.

5. FET nach Anspruch 4,
bei dem diese Siliziumschicht in einem Bereich rings um den Steg (4) vollständig entfernt ist.

6. FET nach einem der Ansprüche 1 bis 5,
bei dem die Höhe (h) des Steges (4) 0,5 µm bis 1 µm beträgt und die Breite (b) des Steges (4) 0,05 µm bis 0,3 µm beträgt.

7. Halbleiterbauelement, in dem ein FET nach einem der Ansprüche 1 bis 6 mit weiteren Funktionselementen (Standard-Bauelementen) integriert ist.
